# EUROPÄISCHE PATENTSCHRIFT

(11) **EP 0 498 258 B1**
(45) Veröffentlichungstag und Bekanntmachung des Hinweises auf die Patenterteilung: **26.07.1995**
(21) Anmeldenummer: 92101294.4
(22) Anmeldetag: 27.01.1992
(51) Int. Cl.: H05K 3/46

(54) **Mikromehrlagenverdrahtung**
Micro multilayer wiring
Micro-câblage multi-couches

(30) Priorität: 07.02.1991 DE 4103750
(43) Veröffentlichungstag der Anmeldung: 12.08.1992
(73) Patentinhaber: SIEMENS AKTIENGESELLSCHAFT, 80333 München (DE)
(72) Erfinder: Birkle, Siegfried, Dr., W-8552 Höchstadt/Aisch (DE); Kammermaier, Johann, Dr., W-8025 Unterhaching (DE); Rittmayer, Gerhard, Dr., W-8520 Erlangen (DE); Schulte, Rolf Winfried, W-8520 Erlangen (DE)

(56) Entgegenhaltungen:
- EP-A- 0 211 180
- EP-A- 0 275 686
- EP-A- 0 282 625
- EP-A- 0 285 797
- IDR INDUSTRIE DIAMANTEN RUNDSCHAU, 18. Jahrgang, Heft 4, Oktober/Dezember 1984, Düsseldorf, B. DISCHLER et al.: "Eigenschaften und Anwendungen harter amorpher Kohlenstoffschichten", Seiten 249-253"
- JOURNAL OF PHYSICS E, SCIENTIFIC INSTRUMENTS, Band 6, Juli 1973, Montreal,Canada, R.G. BOSISIO et al. "Generation of large volume microwave plasmas", Seiten 628-630
- ELECTRIC COMPONENTS CONFERENCE, 34. Ausgabe, Mai 14-16, 1984, Hyatt Regency Hotel, New Orleans, Louisiana, USA KUNIO MORIYA et al."High-Density multilayer interconnection with photo-sensitive polyimide dielectric and electroplating conductor" Seiten 82-87
- PROCEEDINGS OF THE 3RD INTERNATIONAL MICROELECTRONICS CONFERENCE, May 21-23,1984, Keio Plaza Hotel, Tokyo, Japan, HIDEKI TSUNETSUGU et al. "Multilayer interconnections using polyimide dielectrics and aluminum conductors",Seiten 235-240

## Beschreibung

Die Erfindung betrifft ein Verfahren zur Herstellung von Mehrlagenverdrahtungselementen, insbesondere auf Leiterplatten.

Zur Erhöhung der Packungsdichte von Schaltkreisen auf Leiterplatten, keramischen Substraten und anderen Trägermaterialien wird das Prinzip der sogenannten Mehrlagenverdrahtung ("multilayer interconnection") angewendet. Dabei werden mehrere Leitungsbahnebenen übereinander angeordnet; sie sind durch organische Isolierschichten voneinander getrennt und nur an Durchkontaktierungsstellen, d.h. Durchgangsöffnungen ("via holes"), galvanisch miteinander verbunden. An derartige Isolierschichten werden folgende Anforderungen gestellt:
- Dicke d ≦ 10 »m, Dielektrizitätszahl ε < 3 und Verlustfaktor tg δ ≦ 5.10⁻³, um Kopplungseffekte (zwischen den Schaltungsebenen) sowie elektrische Signalverzerrungen und -dämpfungen gering zu halten.
- Planarisierung der darunter befindlichen Leitungsbahnstruktur.
- Thermische Stabilität bzw. Formbeständigkeit bis 270°C, um Tauchlötbarkeit zu gewährleisten.
- Maßhaltigkeit bei thermischer und mechanischer Druckbelastung, d.h. es dürfen keine bleibenden Dimensionsänderungen erfolgen.
- Der thermische Ausdehnungskoeffizient soll möglichst wenig verschieden sein von demjenigen der metallischen Leitungsbahnen.
- Haftfestigkeit für die abgeschiedenen, strukturierten metallischen Leitungsbahnen muß gewährleistet sein; Dicke der Metallschicht: ca. 10 »m.
- Strukturierbarkeit mittels eines photolithographischen Ätzprozesses muß gegeben sein, damit die Durchkontaktierungsstellen erzeugt werden können; Durchmesser der Durchkontaktierungsstellen: ≦ 30 »m.
- Zur Erzeugung der Leitungsbahnen mit einer Breite und einem Abstand von jeweils ca. 10 »m muß ein Photostrukturierungsprozeß durchgeführt werden können.
- Es darf keine oder nur eine sehr geringe Wassersorption erfolgen, damit feuchtebedingte dielektrische Änderungen nicht zu Störungen führen.

Nach dem derzeitigen Stand der Technik werden zur Mikromehrlagenverdrahtung auf Leiterplatten (LSI-Technik) als Zwischenisolierschichten strukturierbare PI-Photolackschichten (PI = Polyimid) verwendet (siehe beispielsweise: "Proceedings of the Electronic Components Conference" 1984, Seiten 73 bis 81 und Seiten 82 bis 87, sowie "Proceedings of the International Microelectronic Conference" 1984, Seiten 235 bis 239). Dabei sind folgende Einzelschritte erforderlich:
(1) Metallisierung des Grundsubstrats, beispielsweise mittels Sputtern, insbesondere mit CuCr oder AlCr;
(2) Aufbringen einer Photolackschicht (Positivresist), beispielsweise aus handelsüblichem AZ-Lack, in einer Dicke von ca. 1 »m;
(3) photolithographische Erzeugung der (gewünschten) Leitungsbahnstruktur auf dem Substrat durch Belichtung und nachfolgende Entwicklung;
(4) galvanische Verstärkung der freiliegenden Leitungsbahnstruktur (mit Cu bzw. Al);
(5) Verzinnen der Leitungsbahnen (bei Cu) sowie Entfernen des Photolacks und der darunter befindlichen Metallschicht, wobei die Zinnschicht (auf den Leitungsbahnen) als Ätzbarriere dient;
(6) Abdecken der gesamten Struktur mit einer ca. 10 »m dicken PI-Photolackschicht, meistens in Form eines Positivresists;
(7) Freilegen von Kontaktflächen in der Grundleitungsbahnebene durch Photolithographie;
(8) Härten der (unbelichteten) Teile der PI-Photolackschicht durch Tempern bis 400°C;
(9) Metallisierung der strukturierten, gehärteten PI-Photolackschicht (mit CuCr bzw. AlCr), entsprechend Verfahrensschritt (1);
(10) Erzeugen einer Leitungsbahnstruktur in der zweiten Schaltungsebene, entsprechend den Verfahrensschritten (2) bis (5);
(11) Abdecken der gesamten Struktur der zweiten Schaltungsebene mit PI-Photolack, Freilegen von Kontaktflächen durch Strukturierung und Härten, entsprechend den Verfahrensschritten (6) bis (8);
(12) gegebenenfalls Bildung weiterer Schaltungsebenen.

Beim Verfahrensschritt (8) bzw. bei den entsprechenden Verfahrensschritten in den weiteren Schaltungsebenen, d.h. bei der Temperung, wird der unbelichtete Teil der PI-Photolackschicht zu einer stabilen isolierenden Trennschicht. Bei diesem Verfahrensschritt entstehen aber, bedingt durch eine unterschiedliche thermische Ausdehnung von Polyimid und Metall sowie durch enorme Scherkräfte aufgrund von Schrumpfungseffekten (bei der Cyclisierungsreaktion im Polyimid), mechanische Spannungen in den Leitungsbahnen der Grundebene, die zu Schäden führen können.

Mit Isolierschichten aus PI-Photolack kann außerdem der vorstehend angegebene Forderungskatalog nur zum Teil erfüllt werden. Bei derartigen Schichten sind nämlich insbesondere die Dielektrizitätszahl, der dielektrische Verlustfaktor und die Wasseraufnahme bzw. die dadurch bedingten dielektrischen Veränderungen vergleichsweise hoch.

Aufgabe der Erfindung ist es, ein Verfahren anzugeben, das die Herstellung von raumsparenden Mehrlagenverdrahtungselementen erlaubt, wobei insbesondere auch die Forderungen erfüllt werden sollen, welche an die zwischen den einzelnen Leitungsbahnebenen angeordneten Isolierschichten gestellt werden.

Dies wird erfindungsgemäß durch ein Verfahren erreicht, das folgende Schritte umfaßt:
(a) Metallisieren des Grundsubstrats;
(b) Aufbringen einer Photolackschicht auf das metallisierte Grundsubstrat;
(c) Erzeugen einer Leitungsbahnstruktur durch Photolithographie;
(d) Verstärken der Leitungsbahnstruktur mit Metall;
(e) Entfernen des Photolacks und der darunter befindlichen Metallschicht;
(f) Abdecken der gesamten Struktur mit einer planarisierenden Plasmapolymerisatschicht auf CF-Basis oder einer Schicht aus amorphem wasserstoffhaltigem Kohlenstoff (a-C:H) mit einem spezifischen elektrischen Widerstand ≧ 10¹⁷Ω.cm, einem optischen Bandabstand ≧ 2 eV und einer Dielektrizitätszahl ≦ 2,3 als isolierende Zwischenschicht;
(g) Aktivieren der Oberfläche der Zwischenschicht mittels eines Sauerstoffplasmas;
(h) Aufbringen einer dünnen Metallschicht auf die aktivierte Zwischenschicht;
(i) Aufbringen eines siliciumhaltigen Photolacks auf die Metallschicht;
(j) Erzeugen von Durchkontaktierungsstellen zu Kontaktflächen in einer Schaltungsebene durch Photolithographie und RIE/O₂-Plasmaätzen;
(k) Strukturieren der siliciumhaltigen Photolackschicht durch Photolithographie zur Erzeugung einer Leitungsbahnstruktur in einer weiteren Schaltungsebene;
(l) Verstärken der Kontaktflächen an den Durchkontaktierungsstellen (l₁) und der Leitungsbahnstruktur der zweiten Schaltungsebene (l₂) mit Metall;
(m) Entfernen des siliciumhaltigen Photolacks und der darunter befindlichen Metallschicht;
(n) Erzeugen weiterer Schaltungsebenen durch wiederholte Durchführung der Schritte (f) bis (m).

Ein wesentliches Merkmal des erfindungsgemäßen Verfahrens zur Mikromehrlagenverdrahtung besteht darin, daß die isolierenden Zwischenschichten planarisierende Plasmapolymerisat- oder a-C:H-Schichten sind. Die erstgenannten Schichten werden durch Plasmapolymerisation hergestellt und bestehen aus einem CF-Polymerisat, d.h. aus einem Polymerisat, das vollständig fluoriert ist. Ein derartiges Polymerisat weist im wesentlichen eine Elementarzusammensetzung entsprechend konventionellem Polytetrafluorethylen (PTFE) auf, nämlich (CF₂)ₙ. Zur Herstellung des Plasmapolymerisats dienen CF-Monomere, d.h. perfluorierte Monomere. Derartige Verbindungen sind beispielsweise Tetrafluorethylen (C₂F₄), Octafluorbutan (C₄F₈) und Perfluordimethylcyclohexan (C₈F₁₆), wobei letzteres bevorzugt zum Einsatz gelangt.

Die Herstellung der Plasmapolymerisatschicht (aus den gasförmigen Monomeren) erfolgt mittels eines Niederdruckplasmas (Druckbereich: 0,1 bis 5 mbar), das mit Hochfrequenzfeldern (HF) angeregt wird; vorzugsweise erfolgt die Anregung des Plasmas mit Mikrowellen (MW), insbesondere mit einer Frequenz von 2,45 GHz (siehe dazu EP-PS 0 132 684). Die Abscheidung des Plasmapolymerisats erfolgt dabei außerhalb des sichtbaren Plasmabereichs. Die Dicke der abgeschiedenen Plasmapolymerisatschicht beträgt im allgemeinen ≦ 10 »m.

Plasmapolymerisatschichten auf CF-Basis weisen folgende Vorteile auf:
- günstige dielektrische Eigenschaften (ähnlich wie PTFE):
   ε = 2,1 bis 2,2; tg δ = 5.10⁻³;
- geringe Wassersorption;
- gute Maßhaltigkeit, auch auf Dauer;
- gute Anpassung der thermischen Ausdehnung an Metalle, insbesondere Kupfer (thermischer Ausdehnungskoeffizient TK des Plasmapolymerisats: 1.10⁻⁵ K⁻¹; TK von Cu: 1,6.10⁻⁵ K⁻¹).

Außerdem werden die Plasmapolymerisatschichten spannungsfrei abgeschieden, da bei der Abscheidung keine Erwärmung des Substrats erfolgt.

Im Vergleich zu Polyimid besitzen CF-Plasmapolymerisate bessere Materialeigenschaften, insbesondere hinsichtlich Dielektrizitätszahl, dielektrischem Verlustfaktor, thermischer Ausdehnung und Wasseraufnahme. Außerdem ergeben sich Vorteile gegenüber konventionellem PTFE, und zwar hinsichtlich der Haftfestigkeit für Metallbeläge und der Oberflächenrauhigkeit (sowohl von geschälten als auch von gesinterten PTFE-Schichten). Auch die Maßhaltigkeit ist besser als bei herkömmlichem PTFE. CF-Plasmapolymerisate sind nämlich einerseits - aufgrund einer amorphen Struktur - thermisch bis 270°C ohne kalorisch meßbare Umwandlungseffekte (DSC-Messung) belastbar, andererseits sind sie zumindest teilweise vernetzt, so daß - im Gegensatz zu PTFE - kein Kaltfluß auftritt.

Amorpher wasserstoffhaltiger Kohlenstoff, kurz a-C:H, wird durch Plasmaabscheidung aus gas- bzw. dampfförmigen Kohlenwasserstoffen, wie Alkanen (z.B. Methan CH₄), Alkenen (z.B. Ethylen C₂H₄) und aromatischen Verbindungen (z.B. Benzol C₆H₆), hergestellt. Bei dieser Kohlenstoffmodifikation sind die C-Atome teils tetraedrisch (sp³), teils trigonal (sp²) hybridisiert und räumlich vernetzt; die amorphe Struktur wird durch den Einbau von Wasserstoff, etwa 10 bis 60 Atom-%, stabilisiert (siehe dazu: "IDR - Industrie Diamanten Rundschau", Bd. 18 (1984), Nr. 4, Seiten 249 bis 253). Das Material a-C:H weist eine bemerkenswert hohe mechanische und chemische Stabilität auf und kann hinsichtlich seiner elektrischen und optischen Eigenschaften in einem weiten Bereich variiert und speziellen Anforderungen angepaßt werden.

Für die Anwendung beim erfindungsgemäßen Verfahren wird a-C:H verwendet, der einen spezifischen elektrischen Widerstand ≧ 10¹⁷Ω.cm, einen optischen Bandabstand ≧ 2 eV und eine Dielektrizitätszahl ≦ 2,3 besitzt. Die Herstellung dieses Materials erfolgt mittels Niederdruckplasmen, welche mit Radiofrequenz- oder Mikrowellenfeldern angeregt werden, beispielsweise mit 13,56 MHz bzw. 2,45 GHz; dabei soll die durch Raumladungen verursachte DC-Potentialdifferenz (self bias-Spannung) zwischen dem zu beschichtenden Substrat und dem Plasma |- 200 V| nicht überschreiten. Die charakteristischen Eigenschaften des a-C:H werden durch die Wahl spezieller Abscheidebedingungen erhalten, nämlich: DC-self bias-Spannung zwischen 0 und 200 V; Gasdruck zwischen 100 und 500 Pa. Die Dicke der abgeschiedenen a-C:H-Schicht beträgt im allgemeinen ≦ 10 »m.

In der beschriebenen Weise hergestellte a-C:H-Schichten weisen folgende Vorteile auf:
- günstige elektrische Eigenschaften:
   ε ≦ 2,3; tg δ ≦ 3.10⁻³;
- geringe Wassersorption;
- thermische Belastbarkeit bis über 270°C;
- gute Maßhaltigkeit infolge mechanischer und thermischer Stabilität.

Außerdem werden die a-C:H-Schichten spannungsfrei abgeschieden, da das Substrat bei der Abscheidung nicht oder nur mäßig erwärmt wird.

Beim erfindungsgemäßen Verfahren wird auf die planarisierende Zwischenschicht aus CF-Plasmapolymerisat bzw. a-C:H eine dünne Metallschicht aufgebracht. Zur Verbesserung der Haftfestigkeit dieser Metallschicht wird die Oberfläche der Zwischenschicht - vor dem Aufbringen des Metalls - aktiviert, und zwar in einem Sauerstoffplasma; dabei erfolgt eine HF-Plasmabehandlung (mit Radiofrequenz- oder Mikrowellen-Anregung). Durch die Aktivierung werden in das Plasmapolymerisat bzw. in den amorphen wasserstoffhaltigen Kohlenstoff oberflächlich polare Atomgruppen eingebaut, welche die Grenzflächenenergie erhöhen. Die Aktivierung mittels Sauerstoffplasma umgeht eine aufwendige naßchemische Aktivierung und bietet den Vorteil, daß der Aktivierungseffekt durch die Dauer der Plasmabehandlung und durch die Plasmabedingungen (Senderleistung, Frequenz der HF-Anregung, Druck, Durchflußrate) steuerbar ist.

Die aktivierte Zwischenschicht wird dann mit der dünnen Metallschicht versehen; dies erfolgt beispielsweise durch Aufsputtern von CuCr bzw. AlCr oder durch Bekeimen mit SnPd in einem Naßprozeß. Anschließend wird auf die dünne Metallschicht ein siliciumhaltiger Photolack aufgebracht, vorzugsweise in Form eines Positivresists. Siliciumhaltige Photoresists weisen den Vorteil einer hohen Ätzresistenz im Sauerstoffplasma auf; derartige Resists sind beispielsweise aus der EP-OS 0 285 797 bekannt. Vorzugsweise wird beim erfindungsgemäßen Verfahren ein Photoresist auf der Basis von Vinylphenol-Vinylsilan-Copolymer verwendet.

Zur Erzeugung von Durchkontaktierungsstellen zu den Kontaktflächen in der ersten Schaltungsebene, d.h. der Grundleitungsbahnebene, wird die Resistschicht nachfolgend - im Bereich der Kontaktflächen - photolithographisch strukturiert (durch Belichten und Entwickeln), und dann wird - in den strukturierten Bereichen - die isolierende Zwischenschicht, einschließlich der dünnen Metallschicht, durch RIE/O₂-Plasmaätzen entfernt. Daraufhin wird die Resistschicht - an gewünschten Stellen - zur Erzeugung einer Leitungsbahnstruktur in der nächsten Schaltungsebene ein zweites Mal photolithographisch strukturiert, wobei die dünne Metallschicht freigelegt wird.

Die dünne Metallschicht in den strukturierten Bereichen der Photoresistschicht, d.h. die metallische Leitungsbahnstruktur, und die metallischen Kontaktflächen an den Durchkontaktierungsstellen werden auf galvanischem Weg mit Metall verstärkt. Diese metallische Verstärkung kann in einem Schritt durchgeführt werden, wobei sie aber differenziert erfolgen muß, d.h. in unterschiedlichem Ausmaß. Deshalb wird vorzugsweise derart verfahren, daß die Metallverstärkung der Kontaktflächen in den Durchkontaktierungsstellen und die Metallverstärkung der Leitungsbahnstruktur (der zweiten Schaltungsebene) getrennt voneinander durchgeführt werden, wobei die metallische Verstärkung der Kontaktflächen vorteilhaft zum Teil bereits vor der zweiten Photostrukturierung der siliciumhaltigen Resistschicht erfolgt. Die metallische Verstärkung erfolgt im allgemeinen mit Kupfer oder Aluminium.

Wenn die metallischen Bereiche, d.h. die Kontaktflächen und die Leitungsbahnstruktur, mit Kupfer verstärkt sind, dann werden sie nachfolgend vorzugsweise noch verzinnt, um eine Ätzbarriere zu schaffen. Dann wird der siliciumhaltige Photoresist, insbesondere durch Lösen, und die darunter befindliche Metallschicht, insbesondere durch Naßätzen, entfernt. Die auf diese Weise freigelegten, gegebenenfalls verzinnten metallischen Strukturen bilden den Ausgangspunkt zum Aufbau der nächsten Schaltungsebene. Als erster Verfahrensschritt schließt sich dabei das Abdecken der gesamten Struktur mit einer isolierenden Zwischenschicht nach der Erfindung an.

Anhand von Ausführungsbeispielen und einer Figur, die den Verfahrensablauf schematisch wiedergibt, soll die Erfindung noch näher erläutert werden. Dabei werden folgende Verfahrensschritte durchlaufen:
(a) Auf ein Keramiksubstrat, das zur Kontaktierung mit Außenanschlüssen versehen ist, wird eine ca. 10 nm dicke Metallschicht aus CuCr aufgesputtert oder eine entsprechend dünne Schicht aus SnPd chemisch abgeschieden.
(b) Auf die dünne Metallschicht wird - in bekannter Weise - ein handelsüblicher Positivresist aufgebracht; Schichtdicke: ca. 1 »m.
(c) In der Resistschicht wird durch photolithographische Strukturierung, die - in bekannter Weise - durch bildmäßige Belichtung und nachfolgende Entwicklung erfolgt, wobei Bereiche der Metallschicht freigelegt werden, eine Leitungsbahnstruktur erzeugt.
(d) Die metallische Leitungsbahnstruktur wird galvanisch mit Kupfer (Cu) verstärkt.
(e) Die Cu-verstärkte Leitungsbahnstruktur wird verzinnt, dann wird der restliche Photoresist und die darunter befindliche Metallschicht (aus CuCr) entfernt, was durch Lösen mittels eines geeigneten Lösungsmittels bzw. durch Abätzen mittels einer geeigneten Ätzlösung erfolgt.
(f) Auf die gesamte Struktur wird eine Plasmapolymerisatschicht auf CF-Basis mit einer Dicke bis zu 10 »m aufgebracht, wobei Perfluordimethylcyclohexan als Monomeres dient. Die Beschichtung mit dem Plasmapolymerisat erfolgt in an sich bekannter Weise (siehe beispielsweise: "J. Phys. E: Sci. Instrum.", Vol. 6 (1973), Seiten 628 bis 630). Dazu dient eine MW-Plasmapolymerisationsanlage, die zur Einkopplung der MW-Energie in den Reaktor (durch ein MW-durchlässiges Fenster) eine sogenannte "slow-wave"-Struktur aufweist, damit über große Substratflächen (beispielsweise 40 cm x 40 cm) gleichmäßig dicke Schichten hergestellt werden können (Dickentoleranz: ± 5 %). Die Dickenhomogenisierung wird dabei durch Hin- und Herbewegen der Substrathalterung unterstützt. Zur Erzielung dielektrisch hochwertiger Schichten werden die Plasmabedingungen so gewählt, daß der sichtbare Bereich des Plasmas denjenigen Bereich, in dem die Schichtabscheidung erfolgt, an keiner Stelle erreicht. Bei einem Druck von ca. 10 Pa und einem Massedurchfluß von ca. 100 sccm wird innerhalb von 30 min eine etwa 9 »m dicke Plasmapolymerisatschicht erzeugt (Abscheiderate: 5 nm.s⁻¹).
(g) Die CF-Plasmapolymerisatschicht wird oberflächlich durch Behandlung mit einem O₂-Niederdruckplasma (MW-Anregung; Druck: 1 Pa; Massedurchfluß: 100 sccm) aktiviert.
(h) Auf die aktivierte Plasmapolymerisatschicht wird - entsprechend Verfahrensschritt (a) - eine ca. 10 nm dicke CuCr- oder SnPd-Schicht aufgebracht.
(i) Die dünne Metallschicht wird mit einer Schicht aus einem siliciumhaltigen Photolack abgedeckt. Dazu dient ein Positivresist auf der Basis eines Vinylphenol-Vinylsilan-Copolymeren, der in üblicher Weise auf das Substrat aufgebracht wird (siehe dazu EP-OS 0 285 797).
(j) Zur Erzeugung der Durchkontaktierungsstellen erfolgt eine Photostrukturierung der Positivresistschicht, der sich ein RIE/O₂-Plasmaätzprozeß anschließt; dabei werden Kontaktflächen in der Grundleitungsebene freigelegt. Durch die Photostrukturierung, die durch Bestrahlen mit UV-Licht und Entwickeln mit einem wäßrig-alkalischen Entwickler erfolgt, wird zunächst eine Maskenstruktur mit Öffnungen in der Resistschicht oberhalb der Kontaktflächen erzeugt. Beim nachfolgenden Plasmaätzprozeß wird dann lediglich an diesen Stellen die CF-Plasmapolymerisatschicht entfernt, da der siliciumhaltige Resist beständig gegen reaktives Ionenätzen im Sauerstoffplasma ist. Die CuCr-Schicht stellt dabei wegen ihrer geringen Dicke keine Ätzbarriere dar.
(k) Durch eine zweite Photostrukturierung der Positivresistschicht, die in entsprechender Weise erfolgt, wird - an gewünschten Stellen - die Leitungsbahnstruktur der zweiten Schaltungsebene erzeugt.
(l) Durch galvanische Abscheidung von Kupfer auf den freiliegenden metallischen Bereichen erfolgt sowohl eine Verstärkung der metallischen Kontaktflächen in den Durchkontaktierungsstellen als auch eine Verstärkung der metallischen Leitungsbahnstruktur. Dabei wird auf der Leitungsbahnstruktur weniger Kupfer abgeschieden als auf den Kontaktflächen.
(m) Die Cu-verstärkten Bereiche, d.h. die Kontaktflächen und die Leitungsbahnstruktur, werden verzinnt, dann wird der restliche siliciumhaltige Photoresist und die darunter befindliche Metallschicht (aus CuCr bzw. SnPd) entfernt. Dies erfolgt im Falle des Resists mit einem geeigneten organischen Lösungsmittel, während das Metall mittels einer FeCl₃-Lösung abgeätzt wird.

Durch Wiederholung der Schritte (f) bis (m) werden nachfolgend weitere Schaltungsebenen aufgebaut.

Anstelle einer Plasmapolymerisatschicht kann auf das mit einer Leitungsbahnstruktur versehene Keramiksubstrat auch eine planarisierende a-C:H-Schicht mit einer Dicke bis zu 10 »m aufgebracht werden (Rᵢₛ ≧ 10¹⁷Ω.cm; Eₒₚₜ ≧ 2 eV; ε ≦ 2,3). Zur a-C:H-Abscheidung dient CH₄ als Prozeßgas (Arbeitsdruck: 200 Pa; Durchflußrate: 50 sccm). Die Abscheidung erfolgt mit einem RF-angeregten Plasma unter kapazitiver Energieeinkopplung bei einem Flächenverhältnis der Elektroden von 1:6. Die HF-Leistungsdichte auf der kleineren Kathode (Substratfläche) beträgt ca. 1,3 W.cm⁻². Die dem HF-Feld überlagerte DC-self bias-Spannung hat einen Wert von ca. 150 V.

Die derart hergestellte a-C:H-Schicht wird in der gleichen Weise weiterbehandelt wie eine CF-Plasmapolymerisatschicht. Hierbei erfolgt zunächst eine oberflächliche Aktivierung mittels eines O₂-Niederdruckplasmas (MW-Anregung; Druck: 1 Pa; Massedurchfluß: 100 sccm) und dann das Aufbringen einer ca. 10 nm dicken CuCr- oder SnPd-Schicht, bevor ein siliciumhaltiger Positivresist aufgebracht wird.

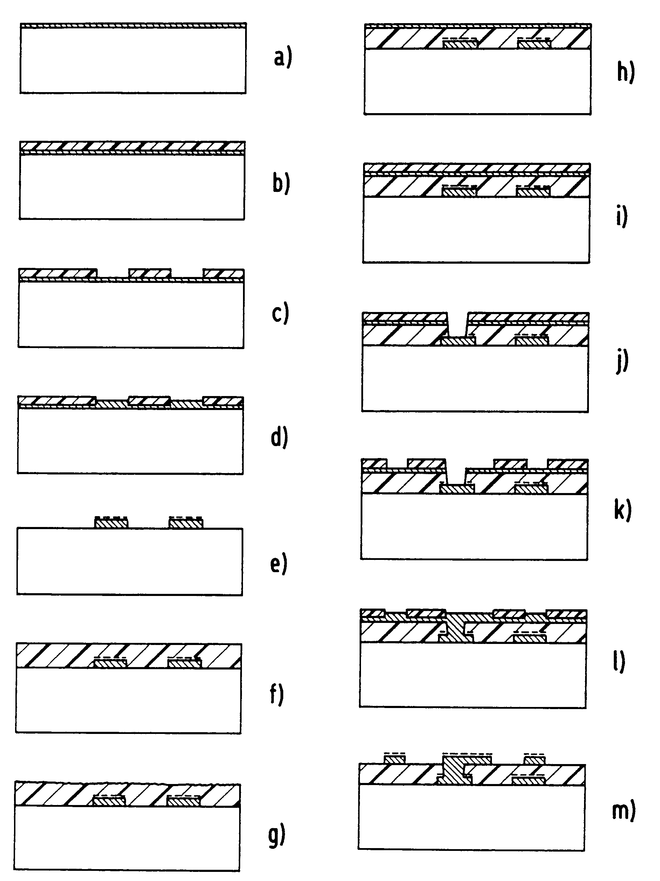

## Patentansprüche

1. Verfahren zur Herstellung von Mehrlagenverdrahtungselementen, insbesondere auf Leiterplatten, **gekennzeichnet** durch folgende Schritte:
(a) Metallisieren des Grundsubstrats;
(b) Aufbringen einer Photolackschicht auf das metallisierte Grundsubstrat;
(c) Erzeugen einer Leitungsbahnstruktur durch Photolithographie;
(d) Verstärken der Leitungsbahnstruktur mit Metall;
(e) Entfernen des Photolacks und der darunter befindlichen Metallschicht;
(f) Abdecken der gesamten Struktur mit einer planarisierenden Plasmapolymerisatschicht auf CF-Basis oder einer Schicht aus amorphem wasserstoffhaltigem Kohlenstoff (a-C:H) mit einem spezifischen elektrischen Widerstand ≧ 10¹⁷Ω.cm, einem optischen Bandabstand ≧ 2 eV und einer Dielektrizitätszahl ≦ 2,3 als isolierende Zwischenschicht;
(g) Aktivieren der Oberfläche der Zwischenschicht mittels eines Sauerstoffplasmas;
(h) Aufbringen einer dünnen Metallschicht auf die aktivierte Zwischenschicht;
(i) Aufbringen eines siliciumhaltigen Photolacks auf die Metallschicht;
(j) Erzeugen von Durchkontaktierungsstellen zu Kontaktflächen in einer Schaltungsebene durch Photolithographie und RIE/O₂-Plasmaätzen;
(k) Strukturieren der siliciumhaltigen Photolackschicht durch Photolithographie zur Erzeugung einer Leitungsbahnstruktur in einer weiteren Schaltungsebene;
(l) Verstärken der Kontaktflächen an den Durchkontaktierungsstellen (l₁) und der Leitungsbahnstruktur der zweiten Schaltungsebene (l₂) mit Metall;
(m) Entfernen des siliciumhaltigen Photolacks und der darunter befindlichen Metallschicht;
(n) Erzeugen weiterer Schaltungsebenen durch wiederholte Durchführung der Schritte (f) bis (m).

2. Verfahren nach Anspruch 1, **dadurch gekennzeichnet**, daß das Verstärken der Kontaktflächen an den Durchkontaktierungsstellen mit Metall (l₁) zum Teil vor dem Strukturieren der siliciumhaltigen Photolackschicht (k) erfolgt.

3. Verfahren nach Anspruch 1 oder 2, **dadurch gekennzeichnet**, daß das Verstärken der Leitungsbahnstrukturen (d, l₂) und der Kontaktflächen (l₁) mittels Kupfer erfolgt, und daß das Kupfer mit einer Ätzbarriere aus Zinn versehen wird.

4. Verfahren nach einem der Ansprüche 1 bis 3, **dadurch gekennzeichnet,** daß die Plasmapolymerisatschicht mittels eines durch Mikrowellen angeregten Niederdruckplasmas erzeugt wird.

5. Verfahren nach Anspruch 4, **dadurch gekennzeichnet**, daß zur Herstellung der Plasmapolymerisatschicht Perfluordimethylcyclohexan eingesetzt wird.

6. Verfahren nach einem der Ansprüche 1 bis 3, **dadurch gekennzeichnet**, daß die a-C:H-Schicht durch Plasmaabscheidung aus Kohlenwasserstoffen mittels Radiofrequenz-Anregung bei einer DC-self bias-Spannung zwischen 0 und 200 V und einem Druck zwischen 100 und 500 Pa erzeugt wird.

7. Verfahren nach Anspruch 6, **dadurch gekennzeichnet**, daß als Kohlenwasserstoff ein Alkan, insbesondere Methan, verwendet wird.

8. Verfahren nach einem oder mehreren der Ansprüche 1 bis 7, **dadurch gekennzeichnet**, daß als siliciumhaltiger Photolack ein Positivresist verwendet wird.

9. Verfahren nach einem oder mehreren der Ansprüche 1 bis 8, **dadurch gekennzeichnet**, daß als siliciumhaltiger Photolack ein Resist auf der Basis von Vinylphenol-Vinylsilan-Copolymer verwendet wird.

## Claims

1. Method of manufacturing multilayer interconnection elements, particularly on printed circuit boards, characterised by the following steps:
(a) metallising of the basic substrate;
(b) application of a photolacquer layer to the metallised basic substrate;
(c) production of a conduction path structure by photolithography;
(d) reinforcement of the conduction path structure with metal;
(e) removal of the photolacquer and of the metal layer located beneath it;
(f) covering of the entire structure with a planarising plasma polymerisate layer on a CF base or a layer made of amorphous hydrogenated carbon (a-C:H) with a specific electrical resistance ≧ 10⁻⁷ Ω.cm, an optical band gap ≧ 2 eV and a dielectric number ≦ 2.3 as an insulating intermediate layer;
(g) activation of the surface of the intermediate layer by means of an oxygen plasma;
(h) application of a thin metal layer to the activated intermediate layer;
(i) application of a silicon-containing photolacquer to the metal layer;
(j) production of transitional contacting points to contact surfaces in one switching plane by photolithography and RIE/0₂ plasma etching;
(k) structuring of the silicon-containing photolacquer layer by photolithography for producing a conduction path structure in another switching plane;
(l) reinforcement of the contact surfaces at the transitional contacting points (l₁) and of the conduction path structure of the second switching plane (l₂) with metal;
(m) removal of the silicon-containing photolacquer and of the metal layer located beneath it;
(n) production of other switching planes by repeated execution of steps (f) to (m).

2. Method according to Claim 1,
characterised in that the reinforcing of the contact surfaces with metal (l₁) at the transitional contacting points is effected, in part, before the structuring of the silicon-containing photolacquer layer (k).

3. Method according to Claim 1 or 2,
characterised in that the reinforcing of the conduction path structures (d, l₂) and of the contact surfaces (l₁) is effected by means of copper, and that the copper is provided with an etching barrier made of tin.

4. Method according to one of Claims 1 to 3,
characterised in that the plasma polymerisate layer is produced by means of a low pressure plasma excited by microwaves.

5. Method according to Claim 4,
characterised in that perfluorodimethylcyclohexane is used for manufacturing the plasma polymerisate layer.

6. Method according to one of Claims 1 to 3,
characterised in that the a-C:H layer is produced by plasma precipitation from hydrocarbons by means of radio frequency excitation with a DC self bias voltage of between 0 and 200 V and at a pressure of between 100 and 500 Pa.

7. Method according to Claim 6,
characterised in that an alkane, in particular methane, is used as the hydrocarbon.

8. Method according to one or more of Claims 1 to 7, characterised in that a positive resist is used as the silicon-containing photolacquer.

9. Method according to one or more of Claims 1 to 8, characterised in that a resist based on vinylphenol/ vinylsilane copolymer is used as the silicon-containing photolacquer.

## Revendications

1. Procédé pour la fabrication d'éléments de câblages multi-couches, notamment sur cartes imprimées, caractérisée par les étapes suivantes:
a) métalliser le substrat de base;
b) appliquer une couche de photorésist sur le substrat de base métallisé;
c) générer une structure de voies conductives par photolithographie;
d) renforcer la structure de voies conductives par du métal;
e) enlever le photorésist et la couche métallique se trouvant en dessous;
f) couvrir la structure entière par une couche aplanissante polymérisée par plasma sur base de CF ou par une couche en carbone amorphe hydrogéné (a-C:H) ayant une résistivité électrique ≧ 10¹⁷ Ω*cm, une bande interdite optique ≧2 eV et de permittivité relative ≦ 2.3, en tant que couche intermédiaire isolante;
g) activer la surface de la couche intermédiaire à l'aide d'un plasma d'oxygène;
h) appliquer une couche mince en métal sur la couche intermédiaire activée;
i) appliquer un photorésist siliceux sur la couche en métal;
j) générer des contacts pénétrants vers des surfaces de contact dans une couche de câblage par photolithographie et par décapage à l'aide d'un plasma RIE/O₂;
k) structurer le photorésist siliceux par photolithographie pour générer une structure de voies conductives dans une couche de câblage supplémentaire;
l) renforcer les surfaces de contact aux contacts pénétrants (l₁) et la structure de voies conductives de la deuxième couche de câblage (l₂) par du métal;
m)écarter le photorésist siliceux et la couche métallique se trouvant en dessous;
n) générer des couches de câblage supplémentaires par répétition successive des étapes (f) à (m).

2. Procédé selon la revendication 1, caractérisé en ce que le renforcement par du métal des surfaces de contact aux contacts pénétrants (l₁) se fait en partie avant la structuration du photorésist silicieux (k).

3. Procédé selon la revendication 1 ou 2, caractérisé en ce que le renforcement des structures de voies conductives (d, l₂) et des surfaces de contact (l₁) se fait à l'aide de cuivre, et que le cuivre est munie d'une couche protectrice en étain contre le décapage.

4. Procédé selon une des revendications 1 à 3, caractérisé en ce que la couche polymérisée par plasma est formée à l'aide d'un plasma à basse pression excité par micro-ondes.

5. Procédé selon la revendication 4, caractérisé en ce que, pour la production de la couche polymérisée par plasma, on utilise du perfluorodiméthylcyclohexane.

6. Procédé selon une des revendications 1 à 3, caractérisé en ce que la couche en a-C: H est formée à partir d'hydrocarbures par dépôt plasmatique moyennant une excitation par radiofréquences, dont la tension constante self-bias est comprise entre 0 et 200 V et dont la pression est comprise entre 100 et 500 Pa.

7. Procédé selon la revendication 6, caractérisé en ce que l'hydrocarbure utilisé est un alcane, notamment du méthane.

8. Procédé selon une ou plusieurs des revendications 1 à 7, caractérisé en ce que le photorésist silicieux utilisé est un résist positif.

9. Procédé selon une ou plusieurs des revendications 1 à 8, caractérisé en ce que le photorésist silicieux utilisé est un résist sur base d'un copolymère de vinylphénol-vinylsilane.
